# EUROPEAN PATENT SPECIFICATION

(11) **EP 2 688 112 B1**
(45) Date of publication and mention of the grant of the patent: **15.05.2019**
(21) Application number: 13176977.0
(22) Date of filing: 18.07.2013
(51) Int. Cl.: H01L 31/048

(54) **Resin substrate solar cell module**
Harzsubstrat-Solarzellenmodul
Module de cellule solaire à substrat de résine

(30) Priority: 19.07.2012 JP 2012160270; 26.12.2012 JP 2012282007
(43) Date of publication of application: 22.01.2014
(73) Proprietor: KIS Co., Ltd., Nagano 384-2206 (JP)
(72) Inventor: Watanabe, Susumu, Saitama, 369-0395 (JP); Yoshimoto, Naoki, Tokyo, 185-8601 (JP); Otake, Junji, Saitama, 369-0395 (JP)
(74) Representative: Beetz & Partner mbB

(56) References cited:
- WO-A1-2011/149119
- US-A- 5 707 459

## Description

### TECHNICAL FIELD:

The present invention relates to a solar cell module making use of a resin substrate. A resin substrate solar cell module as described in the preamble portion of patent claim 1 has been known from WO 2011/149119 A1.

### BACKGROUND ART:

Functionalization including a weight reduction of a solar cell module becomes increasingly important in the midst of an accelerated introduction of natural energy.

A cover glass accounts for about 50% of the weight of a solar cell module and thus the weight reduction of the cover glass is important for the weight reduction of the solar cell module. In relation to such a request, it is desirable to use a transparent resin substrate including a polycarbonate substrate in place of a conventional glass material and a substance made by adding a coupling agent to an EVA (ethylene-vinyl acetate copolymer) or an olefin copolymer has been used as a transparent filled resin.

JP 2012-99613 A discloses a solar cell module formed by stacking a weather-resistant layer, a power-generating member, and a polycarbonate substrate in this sequence and interposing a thermoplastic resin between the power-generating member and the polycarbonate substrate.

JP 2012-49467 A discloses a solar cell module formed by stacking an encapsulating resin layer, a solar cell element, another encapsulating resin layer, and a back sheet in this sequence.

WO 2011/149119 A1 discloses a resin substrate solar cell module comprising: a plurality of solar cells; a plurality of support posts disposed between the adjacent solar cells; and two transparent resin substrates.

US 5 707 459 A1 describes a solar cell module provided with a heat-fused portion. The solar cell module comprises a solar cell encapsulated through a filler between a surface protective layer and a back face protective layer. Said surface protective layer is welded to said back face protective layer by way of heat fusion.

### SUMMARY OF THE INVENTION:

A resin substrate solar cell module according to the present invention is a solar cell module including a plurality of solar cells, a plurality of support posts disposed between adjacent solar cells, and two transparent resin substrates, in which the plural solar cells and support posts are disposed between the two transparent resin substrates, a void section between the two transparent resin substrates is filled with a transparent filled resin, and peripheries of the two transparent resin substrates are welded with a resin which is a polymer having a molecular structure formed by polymerizing an identical monomer to the one forming the transparent resin substrates.

In the resin substrate solar cell module, the solar cells may desirably be formed of crystalline silicon.

In the resin substrate solar cell module, the transparent resin substrates may desirably be formed of polycarbonate.

In the resin substrate solar cell module, the transparent filled resin may desirably be formed of a silicone resin.

In the resin substrate solar cell module, the support posts may desirably be formed of polycarbonate.

In the resin substrate solar cell module, the peripheries of the two transparent resin substrates may desirably be welded by laser welding or infrared thermal welding.

In the resin substrate solar cell module, the peripheries of the two transparent resin substrates may desirably be fixed with a frame filled with an encapsulating resin.

In the resin substrate solar cell module, the solar cells may desirably be bifacial solar cells.

In the resin substrate solar cell module, a resin inflow section may desirably be formed at a part of the void section.

In the resin substrate solar cell module, a coated membrane may desirably be formed over the inner wall of the resin inflow section or at the inner wall of the resin inflow section.

In the resin substrate solar cell module, the resin inflow section may desirably be a space partitioned with a resin having a repeating unit identical to the transparent resin substrates, and an opening through which the transparent filled resin can flow may desirably be formed at a part of the resin.

In the resin substrate solar cell module, the moisture vapor transmission rate of the coated membrane may desirably be not more than 100 g/(m²·day).

The present invention makes it possible to absorb a stress caused by difference in thermal expansion between transparent resin substrates and a crystalline silicon wafer by a transparent filled resin, and to protect the crystalline silicon wafer against wind pressure and hailing by installing support posts between the two transparent resin substrates.

Further, the present invention makes it possible to overcome the expansion of the module and stress concentration at a welded part caused by the thermal expansion of the transparent filled resin in spite of the fact that the transparent filled resin having the small Young's modulus is used in the solar cell module making use of light-weight resin substrates.

### BRIEF DESCRIPTION OF THE DRAWINGS:

Fig. 1 is a schematic front view showing a resin substrate solar cell module of an example;
Fig. 2 is a partial sectional view showing the resin substrate solar cell module of the example;
Fig. 3 is a schematic side view showing a wiring structure of crystalline silicon solar cells of the example;
Fig. 4 is a flowchart showing processes for manufacturing the resin substrate solar cell module the an example; and
Fig. 5 is a schematic front view showing a resin substrate solar cell module of another example.

### DETAILED DESCRIPTION OF THE PREFERRED EMBODIMENTS:

In a solar cell module making use of a light-weight resin substrate including a polycarbonate substrate, phenomena of a warping of the module and an exfoliation of a filled resin from the transparent resin substrate or a silicon wafer occur by an influence of difference in a linear thermal expansion coefficient between the transparent resin substrate and the silicon wafer. In order to mitigate the drawbacks, a silicone resin having a small Young's modulus is used as a transparent filled resin. By so doing, it is possible to reduce stress concentration caused by the difference in the linear thermal expansion coefficient between the transparent resin substrate and the silicon wafer.

However, the cubic thermal expansion coefficient of a transparent filled resin including a silicone resin having a small Young's modulus is 1% or more and the warping of the module and stress concentration at a sealed part are caused in accordance with the expansion of the silicone resin if the temperature of the solar cell module rises on a clear day.

An object of the present invention is to prevent the warping of the module and the stress concentration at the sealed part coming along with the expansion of the transparent filled resin such as a silicone resin in the solar cell module making use of the resin substrate.

A resin substrate solar cell module according to an embodiment of the present invention is explained hereunder in reference to drawings.

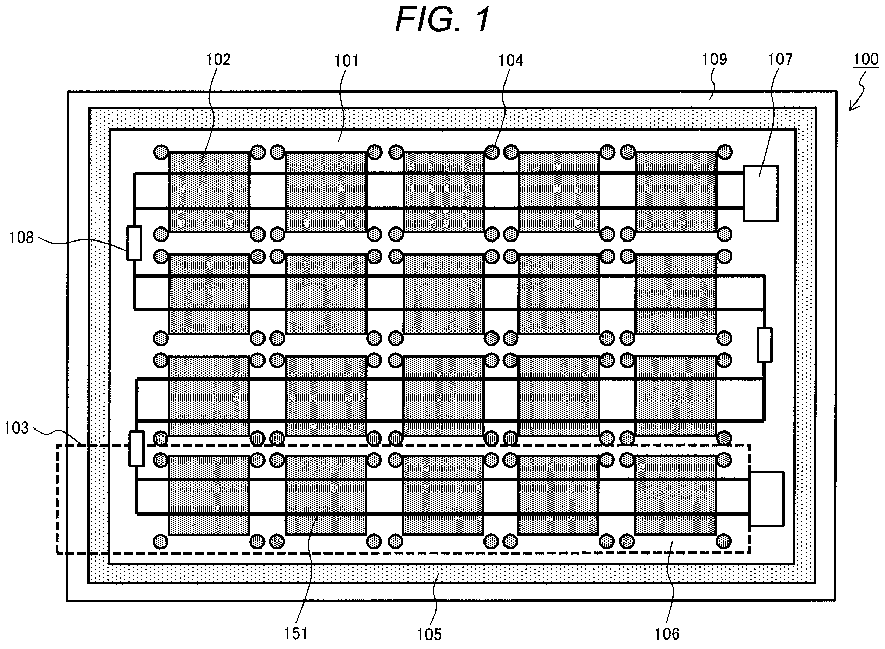

Fig. 1 is a schematic view of a solar cell module (resin substrate solar cell module) making use of light-weight resin substrates. Fig. 1 is an example of the present invention and the structure is not limited at all by the schematic view of Fig. 1.

In the figure, a resin substrate solar cell module 100 is configured by interposing a plurality of crystalline silicon solar cells 102 and a plurality of support posts 104 between two transparent resin substrates 101. The support posts 104 are disposed between adjacent crystalline silicon solar cells 102 so that the transparent resin substrates 101 may not be deformed. A void section that is located between the two transparent resin substrates 101 and is the part not occupied with the crystalline silicon solar cells 102 and the support posts 104 is filled with a transparent filled resin 106 (a silicone resin or the like). Adjacent crystalline silicon solar cells 102 are electrically coupled through wire ribbons 151. That is, the wire ribbons 151 configure wiring. Crystalline silicon solar cells 102 arrayed in a line configure a string 103.

The peripheries of the two transparent resin substrates 101 are welded with a resin having a repeating unit identical to the transparent resin substrates 101. The welded part configures a weld band 105. A frame 109 is formed at the periphery of the weld band 105. Between the two transparent resin substrates 101, terminal boxes 107 and bypath diodes 108 are disposed in addition to those components. Here, "resin having a repeating unit identical" means a polymer having a molecular structure formed by polymerizing an identical monomer. Polycarbonate and silicone resin that will be described later are examples thereof.

As the transparent resin substrates 101, an engineering plastic type transparent substrate such as a polycarbonate substrate may desirably be used in order to give the function of a sound insulating wall to a solar cell module. Polycarbonate is most suitable as the transparent resin substrates 101 on the point that it is excellent in weather resistance, strength, and flame resistance that are necessary requirements of a solar cell module. In addition, polycarbonate satisfies impact resistance and thermal resistance.

The thickness of polycarbonate is decided in consideration of strength, fracture property, and others. For example, the thicknesses of two carbonate substrates to be combined may be 6 mm and 4 mm, respectively. The size of a solar cell module may be a regular size of 1,000 mm x 2,000 mm.

Polycarbonate is known to undergo light degradation caused by ultraviolet rays and thermal degradation caused by infrared rays. When a solar cell module is installed outdoors in particular, it is necessary for resin substrates to have weather resistance and it is desirable to use an arbitrary hard-coat-treated material.

Strings 103 including crystalline silicon solar cells 102 are installed over one of transparent resin substrates 101. Since the gap between the crystalline silicon solar cells 102 and the transparent resin substrates 101 is finally filled with a transparent filled resin 106, it is desirable to have a space between the strings 103 and the transparent resin substrates 101 by an arbitrary gap mechanism (a spacer or the like) when the strings 103 are installed. The space can be decided arbitrarily in the range of 0.5 mm to 10 mm but a smaller space is desirable from the viewpoint of reducing the quantity of the transparent filled resin 106 to the least possible extent. It is desirable to install bypath diodes 108 in order to couple the strings 103 in consideration of the influence caused when wire ribbons 151 break.

Crystalline silicon solar cells 102 may be formed of a multicrystal or a monocrystal.

In the strings 103, the length of the wire ribbons 151 may desirably have an allowance because the wire ribbons 151 are stretched in association with the elongation of the transparent resin substrates 101 caused by linear thermal expansion. With regard to allowance in the length of the wire ribbons 151, it is desirable to adopt a structure that allows the elongation of the transparent resin substrates 101 to be sufficiently absorbed by estimating the allowance from linear thermal expansion assessed from the actual dimensions of the transparent resin substrates 101 and the crystalline silicon solar cells 102. Lighting function can be granted by fixing an arbitrary number of the strings 103 to the transparent resin substrates 101.

Although the number of the support poles 104 allocated between adjacent crystalline silicon solar cells 102 is set at four in the figure, the number is not limited to four but may be one for example.

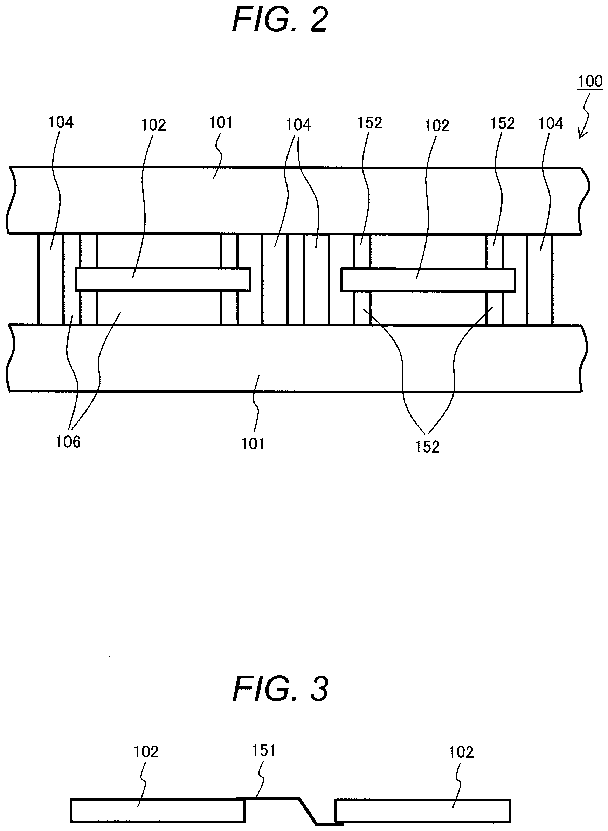

Fig. 2 shows a partial cross-section of a resin substrate solar cell module shown in Fig. 1.

In the figure, crystalline silicon solar cells 102 are installed between two transparent resin substrates 101 supported by support poles 104 and spacers 152. The void section (open space) except the crystalline silicon solar cells 102, the support poles 104, and the spacers 152 is filled with a transparent filled resin 106. In other words, the crystalline silicon solar cells 102 are not directly in contact with the transparent resin substrates 101 and the gap between the crystalline silicon solar cells 102 and the transparent resin substrates 101 is filled with the transparent filled resin 106. By the configuration, the elongation of the transparent resin substrates 101 caused by linear thermal expansion is absorbed by the transparent filled resin 106 and hence the crystalline silicon solar cells 102 come to be hardly broken.

Fig. 3 is a schematic side view showing a wiring structure of crystalline silicon solar cells in an example.

The figure shows adjacent two crystalline silicon solar cells 102 and a wire ribbon 151 to electrically couple them. The wire ribbon 151 connects the top face of one of the crystalline silicon solar cells 102 to the bottom face of the other of the crystalline silicon solar cells 102. Allowance is given to the length of the wire ribbon 151 in preparation for the case where the distance between the two crystalline silicon solar cells 102 may vary. By so doing, the wire ribbon 151 does not break even when transparent resin substrates 101 are elongated.

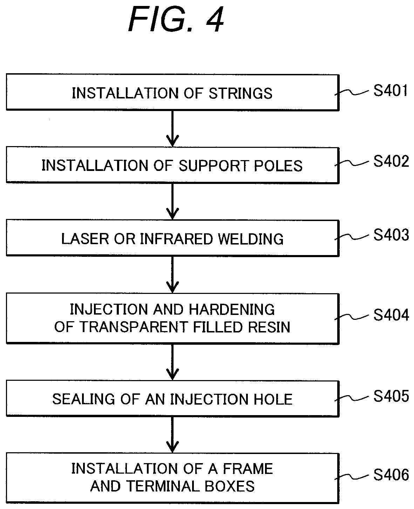

Fig. 4 shows an example of processes for manufacturing a resin substrate solar cell module in an example. The manufacturing processes shown in Fig. 4 do not limit means for implementing the present invention at all. Here, the reference numerals of the members shown below comply with Fig. 1.

Firstly, strings 103 are installed over a transparent resin substrate 101 (S401). Successively, support poles 104 are installed over the transparent resin substrate 101 (S402) . In Fig. 1, the configuration of allocating columnar support posts 104 at the four corners of each of the crystalline silicon solar cells 102 is adopted. The support posts 104 may desirably be formed of a material identical to the transparent resin substrate 101 and the most appropriate material is polycarbonate. As a method for fixing the support poles 104, an arbitrary method including a fixing method using a various adhesive can be adopted.

Successively, in order to contain a transparent filled resin 106, another transparent resin substrate 101 is installed over the transparent resin substrate 101 to which the strings 103 including the crystalline silicon solar cells 102 and the support poles 104 are fixed and the circumference (periphery) of the two transparent resin substrates 101 is welded by a laser beam or infrared rays (S403). On this occasion, it is desirable that the two transparent resin substrates 101 are formed of an identical material and the material is polycarbonate in particular.

A method for welding the two transparent resin substrates 101 by laser welding is explained hereunder.

A weld band 105 (polycarbonate weld band) colored to absorb a laser beam is interposed at the circumference of the two transparent resin substrates 101 comprising polycarbonate. The polycarbonate weld band is colored mostly in black for the purpose of laser absorption. The thickness of the polycarbonate weld band is decided in consideration of the quantity of the transparent filled resin 106. In the laser welding, a commercially-available apparatus may be used and a versatile welding method can be used.

Otherwise, infrared welding can be used. In the case of infrared welding, a light source is set in conformity with the light absorber of the polycarbonate itself and hence the polycarbonate weld band is not necessarily colored. The infrared welding can be carried out with a versatile apparatus.

When the two transparent resin substrates 101 comprising polycarbonate are welded, an injection hole to inject the transparent filled resin 106 is formed beforehand.

The following effects are obtained when the welding is applied by a laser beam or infrared rays.

Firstly, since a material identical to the transparent resin substrates 101 is used for the welding, poor bonding and stress concentration caused by difference in thermal expansion coefficient do not occur. Secondly, when the welding is applied, they are bonded instantaneously and hence droop of an adhesive or the like does not occur.

Successively, the transparent filed resin 106 is: injected in the resin substrate solar cell module 100 formed by welding the two transparent resin substrates 101 comprising polycarbonate by a laser beam or infrared rays; and hardened (5404) . As the transparent filed resin 106, a resin material having a Young' s modulus of not more than 1 MPa and a high light permeability is desired in consideration of difference in linear thermal expansion coefficient between polycarbonate and crystalline silicon solar cells 102 and the Young's modulus of the wire ribbons 151. From the viewpoint, a silicone resin is desirably used. The hardening condition is not particularly limited in the present invention although some silicone resins are retained for a long period of time at room temperature and some other silicone resins are heated at a constant temperature in accordance with the characteristics of the silicone resin.

After the hardening process of the transparent filled resin 106, the injection hole is sealed by an arbitrary method (S405). The sealing can be carried out with a weld band 105 by laser or infrared thermal welding but is not particularly limited.

Wire ribbons 151 are coupled to terminal boxes 107 in order to secure the electrical connection of the resin substrate solar cell module 100 and the insulative safety of the wiring section. Further, an aluminum-made frame 109 is installed around the circumference of the resin substrate solar cell module in order to secure safety against wind pressure and others (S406) . A caulking treatment with a filled resin is applied to the inside of the frame 109 in order to improve reliability at the welded part of the two transparent resin substrates comprising polycarbonate. As the filled resin, a rubber material such as butyl rubber or silicon rubber may desirably be used.

A resin substrate solar cell module can be obtained through the above manufacturing processes.

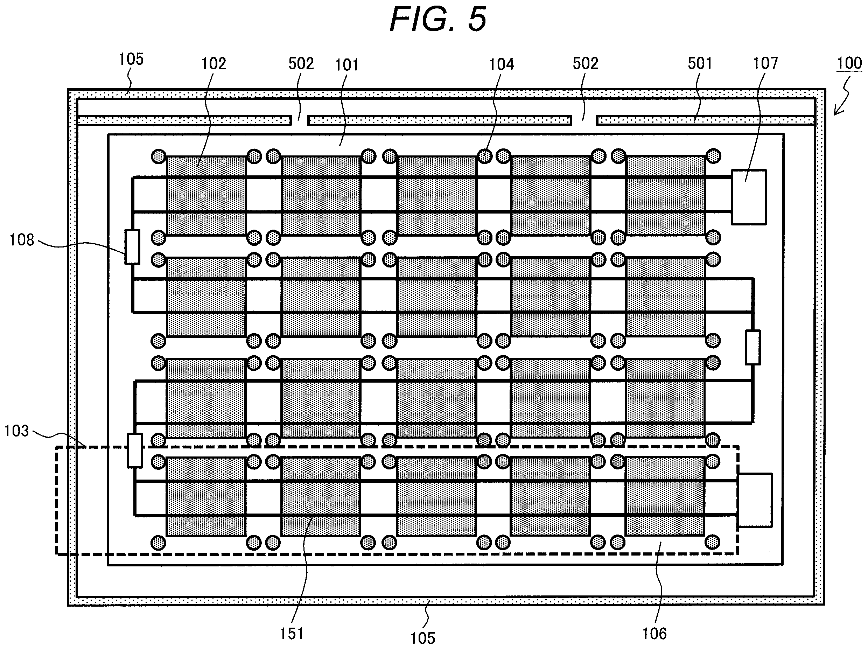

Fig. 5 is a schematic front view showing a resin substrate solar cell module in another example.

The explanation of the configuration explained in Fig. 1 is omitted in the figure.

In Fig. 5, a weld band 501 is installed inside a weld band 105. The weld band 501 has openings 502. An air layer is formed in a region between the weld band 105 and the weld band 501 so that a transparent filled resin 106 may flow in through the openings 502 when the transparent filled resin 106 thermally expands. In other words, the region provides an allowance (space) where the expanded transparent filled resin 106 floods. The region can also be called "a resin inflow section". The resin inflow section is a space partitioned by a resin identical to transparent resin substrates 101.

By the configuration, it is possible to prevent the warping of a module and stress concentration at a sealed part coming along with the expansion of the transparent filled resin 106. The capacity of the region is set at a value larger than the theoretical maximum volume of thermal expansion of the transparent filled resin 106.

Further, a coated membrane for inhibiting moisture from intruding may desirably be disposed over the inner wall of the region. The reason is that the polycarbonate resin constituting the transparent resin substrates 101 permeates water vapor and hence moisture and other water in the atmosphere, though slightly, may possibly intrude in the region, although the region is tightly sealed and is isolated from the atmosphere. As the coated membrane, a synthetic oil, a vegetable oil or the like having a moisture vapor transmission rate lower than the transparent resin substrates 101 can be used and in particular a synthetic oil having a high oxidation resistance is desirably used.

In Fig. 5, however, such a frame 109 as shown in Fig. 1 is not installed at the periphery of the weld band 105. Nevertheless, it is preferable to cover the weld band 105 with a frame comprising aluminum or the like.

As stated above, the advantages of the present invention are firstly the prevention of breakage, secondly sound insulation function, and thirdly lighting. Details of the concrete advantages are as follows.

The present invention makes it possible to obtain a highly reliable solar cell module since the stress caused by the difference in linear thermal expansion coefficient from crystalline silicon solar cells is absorbed by a transparent filled resin comprising a silicone resin in spite of the fact that transparent resin substrates comprising polycarbonate are used.

Further, the present invention makes it possible to obtain a solar cell module excellent in weather resistance and stress characteristics since the module is manufactured through welding treatment using a laser beam or infrared rays.

Furthermore, the present invention makes it possible to provide a solar cell module that can avoid the influence of warping of transparent resin substrates comprising polycarbonate caused by wind pressure and hailing by being supported with support poles.

In addition, the present invention makes it possible to obtain flame resistance and weather resistance since a resin substrate solar cell module includes transparent resin substrates comprising polycarbonate.

Moreover, in the present invention, it is possible to obtain a sufficiently high durability against wind and rain since the method for welding the circumference of two transparent resin substrates with a resin component having a repeating unit identical to the resin substrates is laser welding or infrared thermal welding and the circumference of the two transparent resin substrates welded with the resin component having the repeating unit identical to the resin substrates is further fixed with a frame filled with an encapsulating resin.

Further, the present invention makes it possible to obtain a good power generating characteristic even when an installation site is not necessarily a site being oriented to the south and having a good sunshine condition since crystalline silicon solar cells are bifacial solar cells.

Furthermore, in the present invention, since a partition wall (weld band) forming a resin inflow section is formed of polycarbonate, it is possible to grant durability also to the partition wall in spite of the fact that light-weight resin substrates are used.

## Claims

1. A resin substrate solar cell module (100) comprising:
a plurality of solar cells (102);
a plurality of support posts (104) disposed between the adjacent solar cells (102); and
two transparent resin substrates (101),
**characterized in that** the plural solar cells (102) and the support posts (104) are disposed between the two transparent resin substrates (101), a void section between the two transparent resin substrates (101) is filled with a transparent filled resin (106), and peripheries of the two transparent resin substrates (101) are welded with a resin which is a polymer having a molecular structure formed by polymerizing an identical monomer to the one forming the transparent resin substrates (101).

2. A resin substrate solar cell module (100) according to claim 1,
wherein the solar cells (102) are formed of crystalline silicon.

3. A resin substrate solar cell module (100) according to claim 1 or 2,
wherein the transparent resin substrates (101) are formed of polycarbonate.

4. A resin substrate solar cell module (100) according to any one of claims 1 to 3,
wherein the transparent filled resin (106) is formed of a silicone resin.

5. A resin substrate solar cell module (100) according to any one of claims 1 to 4,
wherein the support posts (104) are formed of polycarbonate.

6. A resin substrate solar cell module (100) according to any one of claims 1 to 5,
wherein the peripheries of the two transparent resin substrates (101) are welded by a laser welding or an infrared thermal welding.

7. A resin substrate solar cell module (100) according to any one of claims 1 to 6,
wherein the peripheries of the two transparent resin substrates (101) are fixed with a frame (109) filled with an encapsulating resin.

8. A resin substrate solar cell module (100) according to any one of claims 1 to 7,
wherein the solar cells (102) are bifacial solar cells.

9. A resin substrate solar cell module (100) according to any one of claims 1 to 8,
wherein a part of the void section has a resin inflow section (502).

10. A resin substrate solar cell module (100) according to claim 9,
wherein a coated membrane is formed over the inner wall of the resin inflow section (502).

11. A resin substrate solar cell module (100) according to claim 9 or 10,
wherein the resin inflow section is a space partitioned with a resin having a repeating unit identical to the transparent resin substrates (101), and an opening (502) through which the transparent filled resin can flow is formed at a part of the resin.

12. A resin substrate solar cell module (100) according to claim 10 or 11,
wherein a moisture vapor transmission rate of the coated membrane is 100 g/(m²·day) or less.

## Patentansprüche

1. Harzsubstrat-Solarzellenmodul (100), umfassend:
mehrere Solarzellen (102);
mehrere Trägerpfosten (104), die zwischen den benachbarten Solarzellen (102) angeordnet sind; und
zwei transparente Harzsubstrate (101),
**dadurch gekennzeichnet, dass** die mehreren Solarzellen (102) und die Trägerpfosten (104) zwischen den zwei transparenten Harzsubstraten (101) angeordnet sind, ein leerer Abschnitt zwischen den zwei transparenten Harzsubstraten (101) mit einem transparenten gefüllten Harz (106) gefüllt ist und Peripherien der zwei transparenten Harzsubstrate (101) mit einem Harz verschweißt sind, das ein Polymer ist, das eine Molekülstruktur aufweist, die durch Polymerisieren eines Monomers ausgebildet ist, das mit dem identisch ist, das die transparenten Harzsubstrate (101) ausbildet.

2. Harzsubstrat-Solarzellenmodul (100) nach Anspruch 1, wobei die Solarzellen (102) aus kristallinem Silicium ausgebildet sind.

3. Harzsubstrat-Solarzellenmodul (100) nach Anspruch 1 oder 2,
wobei die transparenten Harzsubstrate (101) aus Polycarbonat ausgebildet sind.

4. Harzsubstrat-Solarzellenmodul (100) nach einem der Ansprüche 1 bis 3,
wobei das transparente gefüllte Harz (106) aus einem Siliconharz ausgebildet ist.

5. Harzsubstrat-Solarzellenmodul (100) nach einem der Ansprüche 1 bis 4,
wobei die Trägerpfosten (104) aus Polycarbonat ausgebildet sind.

6. Harzsubstrat-Solarzellenmodul (100) nach einem der Ansprüche 1 bis 5,
wobei die Peripherien der zwei transparenten Harzsubstrate (101) mittels eines Laserschweißens oder eines Infrarotwärmeschweißens verschweißt sind.

7. Harzsubstrat-Solarzellenmodul (100) nach einem der Ansprüche 1 bis 6,
wobei die Peripherien der zwei transparenten Harzsubstrate (101) mit einem Rahmen (109) befestigt sind, der mit einem Verkapselungsharz gefüllt ist.

8. Harzsubstrat-Solarzellenmodul (100) nach einem der Ansprüche 1 bis 7,
wobei die Solarzellen (102) zweiflächige Solarzellen sind.

9. Harzsubstrat-Solarzellenmodul (100) nach einem der Ansprüche 1 bis 8,
wobei ein Teil des leeren Abschnitts einen Harzeinströmabschnitt (502) aufweist.

10. Harzsubstrat-Solarzellenmodul (100) nach Anspruch 9, wobei über der Innenwand des Harzeinströmabschnitts (502) eine beschichtete Membran ausgebildet ist.

11. Harzsubstrat-Solarzellenmodul (100) nach Anspruch 9 oder 10,
wobei der Harzeinströmabschnitt ein Raum ist, der mit einem Harz abgeteilt ist, das eine Wiederholungseinheit aufweist, die identisch mit den transparenten Harzsubstraten (101) ist, und an einem Teil des Harzes eine Öffnung (502) ausgebildet ist, durch die das transparente gefüllte Harz fließen kann.

12. Harzsubstrat-Solarzellenmodul (100) nach Anspruch 10 oder 11,
wobei eine Feuchtigkeitsdampf-Durchlassrate der beschichteten Membran 100 g/(m² · Tag) oder weniger beträgt.

## Revendications

1. Module de cellule solaire à substrat en résine (100) comprenant:
une pluralité de cellules solaires (102);
une pluralité de montants de support (104) disposés entre les cellules solaires adjacentes (102); et
deux substrats de résine transparents (101),
**caractérisé en ce que** la pluralité de cellules solaires (102) et les montants de support (104) sont disposés entre les deux substrats de résine transparents (101), une section vide située entre les deux substrats de résine transparents (101) est remplie d'une résine de remplissage transparente (106), et les périphéries des deux substrats de résine transparents (101) sont soudées à l'aide d'une résine qui est un polymère ayant une structure moléculaire formée par la polymérisation d'un monomère identique à celui formant les substrats de résine transparents (101).

2. Module de cellule solaire à substrat en résine (100) selon la revendication 1, dans lequel les cellules solaires (102) sont formées de silicium cristallin.

3. Module de cellule solaire à substrat en résine (100) selon la revendication 1 ou la revendication 2, dans lequel les substrats résine transparents (101) sont formés de polycarbonate.

4. Module de cellule solaire à substrat en résine (100) selon l'une quelconque des revendications 1 à 3, dans lequel la résine de remplissage transparente (106) est formée d'une résine de silicone.

5. Module de cellule solaire à substrat en résine (100) selon l'une quelconque des revendications 1 à 4, dans lequel les montants de support (104) sont formés de polycarbonate.

6. Module de cellule solaire à substrat en résine (100) selon l'une quelconque des revendications 1 à 5, dans lequel les périphéries des deux substrats de résine transparents (101) sont soudées par un soudage au laser ou par un soudage thermique à infrarouge.

7. Module de cellule solaire à substrat en résine (100) selon l'une quelconque des revendications 1 à 6, dans lequel les périphéries des deux substrats de résine transparents (101) sont fixées à l'aide d'un cadre (109) rempli d'une résine d'encapsulation.

8. Module de cellule solaire à substrat en résine (100) selon l'une quelconque des revendications 1 à 7, dans lequel les cellules solaires (102) sont des cellules solaires bifaciales.

9. Module de cellule solaire à substrat en résine (100) selon l'une quelconque des revendications 1 à 8, dans lequel une partie de la section vide comporte une section d'entrée de résine (502).

10. Module de cellule solaire à substrat en résine (100) selon la revendication 9, dans lequel une membrane revêtue est formée sur la paroi interne de la section d'entrée de résine (502).

11. Module de cellule solaire à substrat en résine (100) selon la revendication 9 ou la revendication 10, dans lequel la section d'entrée de résine est un espace partitionné par une résine ayant une unité de répétition identique aux substrats de résine transparents (101), et une ouverture (502) à travers laquelle la résine de remplissage transparente peut s'écouler est formée au niveau d'une partie de la résine.

12. Module de cellule solaire à substrat en résine (100) selon la revendication 10 ou la revendication 11, dans lequel un taux de transmission de vapeur humide de la membrane revêtue est inférieur ou égal à 100 g/(m² jour).
